# EUROPÄISCHE PATENTSCHRIFT

(11) **EP 1 456 060 B1**
(45) Veröffentlichungstag und Bekanntmachung des Hinweises auf die Patenterteilung: **08.06.2005**
(21) Anmeldenummer: 02796606.8
(22) Anmeldetag: 11.12.2002
(51) Int. Cl.: B60R 16/02, H05K 7/14, H05K 5/00

(54) **ELEKTRISCHES STEUERGERÄT SOWIE HERSTELLUNGSVERFAHREN**
ELECTRIC CONTROL DEVICE AND METHOD FOR THE PRODUCTION THEREOF
APPAREIL DE COMMANDE ELECTRIQUE ET SON PROCEDE DE PRODUCTION

(30) Priorität: 12.12.2001 DE 10161104
(43) Veröffentlichungstag der Anmeldung: 15.09.2004
(73) Patentinhaber: KNORR-BREMSE SYSTEME FÜR NUTZFAHRZEUGE GMBH, 80809 München (DE)
(72) Erfinder: LECHNER, Klaus, 91301 Forchheim (DE); KLINGER, Herbert, 90455 Nürnberg (DE); THOMAS, Gerhard, 90768 Fürth (DE); WUTZ, Karl, 92369 Sengenthal (DE)
(74) Vertreter: Schönmann, Kurt, Dr.
(86) Internationale Anmeldenummer: PCT/EP2002/014054
(87) Internationale Veröffentlichungsnummer: WO 2003/053745

(56) Entgegenhaltungen:
- EP-A- 0 792 094
- DE-A- 4 342 978
- DE-A- 19 712 099
- DE-A- 19 803 359
- US-A- 5 574 254
- PATENT ABSTRACTS OF JAPAN vol. 1999, no. 13, 30. November 1999 (1999-11-30) -& JP 11 233988 A (JIDOSHA KIKI CO LTD), 27. August 1999 (1999-08-27)

## Beschreibung

Die Erfindung betrifft ein elektrisches bzw. elektropneumatisches und/oder elektrohydraulisches Steuergerät, insbesondere ein Schalt- oder Steuergerät für Kraftfahrzeuge sowie ein Verfahren zu seiner Herstellung.

Derartige elektrische bzw. elektropneumatische und/oder elektrohydraulische Steuergeräte können in der Praxis bspw. als Steuergeräte für Fahrzeugbremsanlagen verwendet werden, wobei eine in den Steuergeräten vorgesehene Leiterplatte typischerweise mit Hilfe von Schrauben auf einer Bodenplatte eines Gehäuses des Steuergeräts befestigt ist. Bei der Montage der Leiterplatte sind mehrere Schritte notwendig; insbesondere sind feste Verbindungen herzustellen, wodurch die Montage relativ aufwendig und teuer wird.

Ein elektrisches Gerät, das insbesondere als Schalt- oder Steuergerät für Kraftfahrzeuge vorgesehen ist, ist aus der DE 43 43 355 A1 bekannt. Dieses bekannte Gerät weist mehrere Stege auf, auf denen eine Leiterplatte aufliegt. Die Leiterplatte wird mit Hilfe von Federn, die einen elastischen, zickzackförmig ausgebildeten Bereich aufweisen, auf dem Steg fixiert. Der elastische Bereich kann an einen als Gegenlager dienenden Zapfen entlang gleiten. Sowohl der Zapfen als auch die Stege weisen eine zum Boden des Gehäuses hin ansteigende Neigung auf, so dass die Leiterplatte mit Hilfe der Federn leicht befestigt werden kann. Dadurch soll eine kostengünstige und montagefreundliche Anordnung der Leiterplatte im Gehäuse ermöglicht werden.

Ein weiteres elektrisches Schalt- und/oder Steuergerät für eine Fahrzeugbremsanlage ist aus der DE 195 28 252 A1 bekannt. Dieses Steuergerät weist einen Gehäuseblock sowie einen Gehäusedeckel auf, der vom Gehäuseblock aufgenommene, elektrische Komponenten des Aggregats abdeckt, und der mindestens einen von außen zugänglichen, elektrischen Steckverbinder aufweist, an dem elektrische Komponenten angeschlossen sind. Das Gerät weist eine lösbare Abdeckung auf, die den Steckverbinder überdeckt, und die zusammen mit dem Gehäusedeckel eine Kabeldurchführung für ein Kabel eines in den Steckverbinder eingesteckten Steckers bildet.

Aus der DE 198 03 359 ist ein Gerät mit einem einseitig offenen Gehäuse mit einer Auflagekante bekannt, auf die eine Leiterplatte aufgelegt wird; ein Gehäusedeckel weist ein umlaufendes elastisches Element auf, mit dem der Gehäusedeckel dichtend auf die Leiterplatte aufgesetzt wird.

Ähnliche Geräte mit einem elastischen Element sind auch in der DE 197 12 099 und der DE 25 40 186 beschrieben.

Ein gattungsgemäßes Gerät ist in der EP-A-792094 beschrieben.

Ein Ziel der Erfindung besteht darin, ein elektrisches Steuergerät zur Verfügung zu stellen, bei dem eine einfache und kostengünstige Fixierung einer elektrischen Leiterplatte ermöglicht ist.

Dieses Ziel der Erfindung wird mit dem Gegenstand der unabhängigen Ansprüche erreicht. Merkmale vorteilhafter Weiterbildungen der Erfindung ergeben sich aus den abhängigen Ansprüchen.

Demgemäß weist ein elektrisches bzw. elektropneumatisches und/oder elektrohydraulisches Steuergerät, das insbesondere zum Einsatz in Kraftfahrzeugen vorgesehen ist, ein einseitig offenes Gehäuse.und mindestens eine in dem Gehäuse'angeordnete, eine elektrische Schaltung tragende Leiterplatte auf. Das Gehäuse weist innerhalb einer Öffnung eine umlaufende bzw. unterbrochene Auflagekante zur Auflage der Leiterplatte auf. Die Leiterplatte wird mittels wenigstens eines elastischen Elements auf die Auflagekante des Gehäuses gedrückt. Erfindungsgemäß ist ein Gehäusedeckel mit zwei umlaufenden Nuten an seiner Innenseite vorgesehen und sind in den Nuten jeweils elastische Elemente eingebracht, wobei das erste elastische Element gegen die Oberseite der Leiterplatte drückt, das zweite elastische Element gegen das Gehäuse drückt und dessen Inneres gegen äußere Medieneinflüsse abdichtet und Gehäuse und Gehäusedeckel miteinander verastet sind.

Dieses erfindungsgemäße elektrische Steuergerät weist den Vorteil einer einfachen Bauweise und gleichzeitig einer guten Abdichtung seines Gehäuseinneren gegen äußere Einflüsse auf. Die Leiterplatte ist ohne zusätzliche Verschraubungen im Gehäuse fixiert. Der Gehäusedeckel kann ebenfalls ohne zusätzliche Verschraubungen oder andersartige Befestigungen mit dem Gehäuse fest verbunden sein.

Eine Ausführungsform der Erfindung sieht hierzu vor, dass der Gehäusedeckel im aufgesetzten Zustand mit dem Gehäuse verrastet ist. Hierzu kann es sinnvoll sein, dass ein umlaufender Rand des Gehäusedeckels das Gehäuse zumindest teilweise umgreift, wodurch eine feste Verrastung der beiden Einzelteile bei gleichzeitig fest fixierter Leiterplatte im Gehäuseinneren ermöglicht ist.

Weiterhin ist vorgesehen, dass ein erstes elastisches Element bei aufgesetztem Gehäusedeckel auf der Leiterplatte aufliegt. Ein zweites elastisches Element kann bei aufgesetztem Gehäusedeckel auf einer umlaufenden Gehäusekante aufliegen, die auf einem größeren Radius angeordnet ist, als das erste elastische Element bzw. eine äußere umlaufende Kante der Leiterplatte. Wenn zudem die elastischen Elemente bei aufgesetztem Gehäusedeckel zumindest teilweise komprimiert sind, ist eine hervorragende Abdichtung des Gehäuseinneren sowie der empfindlichen elektrischen Schaltungen auf der Leiterplatte gegen äußere Medieneinflüsse möglich.

Zu diesem Zweck können die elastischen Elemente jeweils im umlaufenden Nuten im Gehäusedeckel angeordnet sein. Auf diese Weise können die elastischen Elemente im entspannten Zustand leicht über die Nuten hinaus ragen und bei aufgesetztem Gehäusedeckel um ein gewisses Volumen komprimiert werden. Diese Komprimierung kann besonders vorteilhaft dann gewährleistet werden, wenn die elastischen Elemente jeweils aus einem Elastomer gebildet sind.

Die Verrastung zwischen Gehäuse und Gehäusedeckel kann mittels Rasthaken und damit korrespondierenden Aussparungen erfolgen. Hierzu können entweder jeweils am Gehäuse oder am Gehäusedeckel Rasthaken vorgesehen sein, in die entsprechende Aussparungen am Gehäuse oder an der Innenseite des überstehenden Randes des Gehäusedeckel eingreifen können. Eine solche Verbindung kann durch einfaches Aufdrücken des Gehäusedeckel hergestellt werden und kann anschließend nicht unbeabsichtigt oder versehentlich gelöst werden, bspw. bei starken Erschütterungen und/oder Vibrationen. Ein Lösen des Gehäusedeckels kommt ausschließlich mittels zusätzlicher Hilfsmittel in Frage.

Das Gehäuse kann beispielsweise aus Metall bestehen, so dass es eine hohe Stabilität und gleichzeitig eine Mediendichtigkeit aufweist. Als Metall hierfür kommt beispielsweise Aluminiumdruckguss mit seinen guten Möglichkeiten hinsichtlich der Formgebung in Frage. Aluminiumdruckguss ist zudem hervorragend zur Ableitung von im Betrieb des Steuergeräts auftretender Verlustwärme geeignet. Das Gehäuse kann auf diese Weise sehr gut als Kühlelement fungieren. Der Gehäusedeckel besteht bei einem Gehäuse aus Metall vorzugsweise aus Kunststoff, bspw. aus Polyamid oder dgl., so dass eine leichte Aufbiegung des umlaufenden Randes zum Verrasten der Einzelteil ermöglicht ist.

Die Leiterplatte kann ggf. über Stützsäulen im Gehäusedeckel zusätzlich fixiert sein und dadurch effektiv gegen Schwingungen und evtl. daraus resultierenden Resonanzanregungen geschützt werden.

Bei einem erfindungsgemäßen Verfahrens zur Herstellung eines elektrischen Steuergeräts gemäß einer der zuvor beschriebenen Ausführungsformen wird ein einseitig offenes Gehäuse mit einer umlaufenden bzw. unterbrochenen Auflagekante innerhalb einer Öffnung bereitgestellt, wonach auf die Auflagekante eine Leiterplatte mit darauf befindlicher elektrischer Schaltung aufgelegt wird. Es wird weiterhin ein Gehäusedeckel mit zwei umlaufenden Nuten in einer Innenseite bereitgestellt, wonach elastische Elemente in die umlaufenden Nuten eingebracht werden. Schließlich wird der Gehäusedeckel auf die Öffnung des Gehäuses unter Verrastung der beiden Teile aufgesetzt.

Beim Aufsetzen des Gehäusedeckels können die elastischen Elemente komprimiert werden, wodurch eine gute Abdichtung des Gehäuseinneren mit seinen elektrischen Komponenten gegen äußere Medieneinflüsse gewährleistet werden kann. Dabei wird das erste elastische Element gegen die Leiterplatte gedrückt und das zweite elastische Element gegen das Gehäuse.

Die elastischen Elemente können in vorteilhafter Weise mittels Spritzgussverfahren in die Nuten des Gehäusedeckels eingebracht werden. Der Gehäusedeckel aus Thermoplast oder Duroplast mit den darin integrierten elastischen Elementen kann in vorteilhafter Weise in einem zweistufigen Spritzgussverfahren hergestellt werden. Dabei wird zunächst der Gehäusedeckel selbst aus Thermoplast hergestellt und in einem zweiten Einspritzvorgang können die elastischen Elemente aus Elastomer eingebracht werden.

Zusammenfassend ergeben sich die folgenden Aspekte der Erfindung. Das beschriebene Steuergerät kann bspw. als elektropneumatischer Modulator einer Fahrzeugbremsanlage Verwendung finden. Solche Modulatoren bestehen aus einem Druckgussgehäuse aus Aluminium und weisen Magnetventile und pneumatische Kolben auf. Eine elektronische Steuerschaltung ist ebenfalls in dem Gehäuse integriert. Die Steuerschaltung umfasst eine mit elektronischen Bauteilen bestückte Leiterplatte, auf der sich zudem eine oder mehrere Steckerleisten, Führungsleisten und ggf. Drucksensoren befinden. Diese Leiterplatte liegt auf einem von einer Dichtfläche erhabenen durchgehenden oder teilweise unterbrochenen Rand bzw. Auflagekante auf. Der erhabene Rand verhindert ein Durchdringen von Feuchtigkeit direkt auf die Leiterplatte, sondern lässt eindringende Feuchtigkeit nach unten abfließen.

Zusätzlich ist das Druckgussgehäuse mittels einer Dichtung nach außen abgeschlossen. Die Leiterplatte ist nicht verschraubt oder vernietet, sondern mittels eines elastischen Elements bzw. einer Gummilippe und einem mit dem Gehäuse verrasteten Deckel geklemmt. Die Leiterplatte ist gegen Kräfte von unten durch Steckkräfte an der Führungsleiste und ggf. pneumatische Anschlüsse des Drucksensors abgestützt. Die Dichtung sowie die Gummilippe bestehen vorzugsweise aus thermoplastischen Elastomeren und können in einem Spritzgusszyklus in den Gehäusedeckel eingespritzt werden.

Im Druckgussgehäuse kann weiterhin ein Durchbruch vorgesehen sein, durch den von außen eine Steckdose aus Kunststoff eingeführt und mittels Rasthaken im Gehäuse verrastet werden kann.

Die Erfindung wird nun anhand von Ausführungsformen mit Bezug auf die beiliegenden Figuren näher erläutert.
- Figur 1: zeigt ein erfindungsgemäßes elektrisches Steuergerät in schematischer Schnittdarstellung.
- Figur 2: zeigt einen schematischen Teilschnitt eines Teils des erfindungsgemäßen elektrischen Steuergeräts gemäß Figur 1.
- Figur 3: zeigt eine schematische Explosionsdarstellung des erfindungsgemäßen elektrischen Steuergeräts.

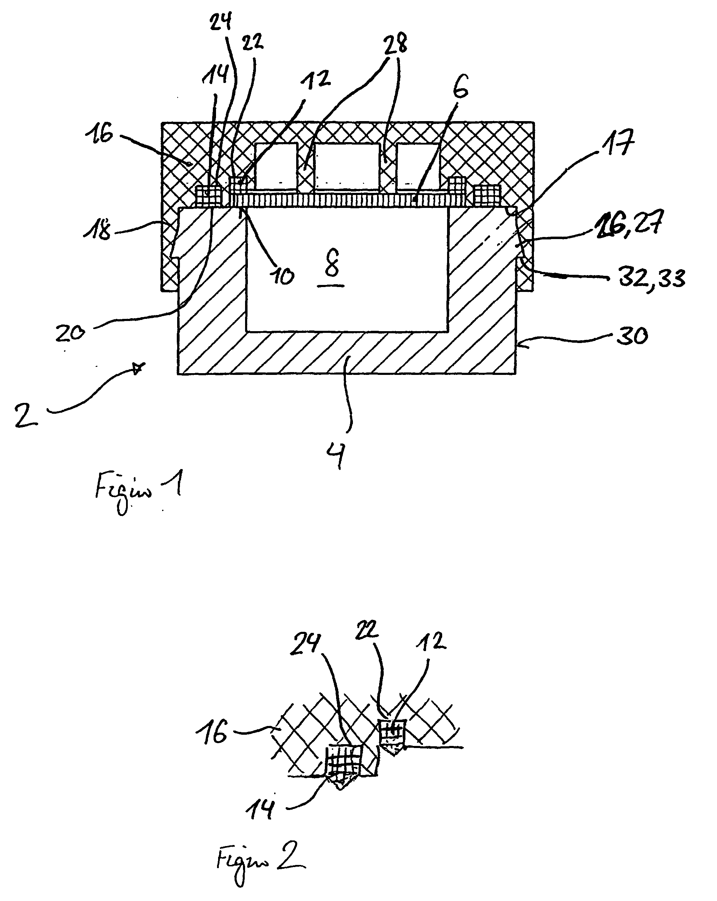

Figur 1 zeigt in einer schematischen Schnittdarstellung ein erfindungsgemäßes elektrisches Steuergerät 2, das insbesondere zum Einsatz in Kraftfahrzeugen, wie LKW und/oder Nutzfahrzeugen, vorgesehen ist. Das elektrische Steuergerät 2 umfasst ein einseitig offenes Gehäuse 4 mit einem darauf befindlichen Gehäusedeckel 16. Eine Öffnung 8 des Gehäuses 4 kann hydraulische, pneumatische und/oder elektrische Komponenten enthalten, die gegen äußere Umwelteinflüsse abgeschlossen sein müssen. Zur elektrischen und/oder pneumatischen oder hydraulischen Verbindung des elektrischen Steuergerätes mit einer äußeren Peripherie sind zweckmäßigerweise hier nicht dargestellte Anschlüsse und/oder Gehäusedurchführungen vorgesehen.

Das im wesentlichen quaderförmige Gehäuse 4 weist eine umlaufende Auflagekante 10 an einer oberen Gehäusekante 20 auf, auf der eine Leiterplatte 6 mit darauf befindlichen elektrischen Schaltungen aufliegt. Die Auflagekante 10 kann wahlweise durchgängig oder unterbrochen sein, so dass sich eine Vielzahl von Abstützstellen für die Leiterplatte 6 ergeben. Die Leiterplatte 6 wird von oben mittels des Gehäusedeckels 16 über ein erstes elastisches Element 12 auf die Auflagekante 10 des Gehäuse gedrückt. Das erste elastische Element 12 ist in einer ersten umlaufenden Nut 22 an einer Innenseite 17 des Gehäusedeckels 16 vorgesehen.

Bei aufgesetztem Gehäusedeckel 16 wird das erste elastische Element 12, das im entspannten Zustand leicht über die erste Nut 22 hinausragt, auf die Oberseite der Leiterplatte 6 gedrückt und dabei komprimiert. Die auf der Leiterplatte 6 befindlichen elektrischen Komponenten werden dadurch nach außen hin abgedichtet und vor evtl. schädlichen Umwelteinflüssen geschützt.

Ein zweites elastisches Element 14 befindet sich in einer zweiten umlaufendem Nut 24 an der Innenseite 17 des Gehäusedeckels, jedoch auf einem größeren Umfang als die ersten Nut 22. Im aufgesetzten Zustand des Gehäusedeckels wird das zweite elastische Element 14, das im entspannten Zustand ebenfalls leicht über die Innenseite 17 des Gehäuses und aus den Umrissen der zweiten Nut 24 hinausragt, gegen die Gehäusekante 20 gedrückt und dabei ebenfalls komprimiert. Das zweite elastische Elemente 14 sorgt für eine sichere Abdichtung der Gehäuseinnenseite sowie der gesamten Leiterplatte 6 gegen Medieneinflüsse von außen.

Das Gehäuse 4 und der Gehäusedeckel 16 sind im aufgesetzten Zustand des Gehäusedeckels 16 über Rasthaken 26 bzw. 27 und damit korrespondierende Aussparungen 32 bzw. 33 fest miteinander verrastet, so dass der Gehäusedeckel 16 in einer definierten Stellung auf dem Gehäuse 4 aufliegt. Ein umlaufender Rand 18 des schalenförmigen Gehäusedeckels 16 umgreift zumindest teilweise die Außenseitenflächen 30 des Gehäuses 4. Das Gehäuse 4 kann an zumindest zwei gegenüberliegenden Außenseitenflächen 30 jeweils mit Rasthaken 26 versehen sein, in die entsprechende Aussparungen 32 an einer Innenseite des umlaufenden Randes 18 des Gehäusedeckels 16 eingreifen. Diese erste Möglichkeit ist beispielhaft in Figur 1 illustriert. Alternativ kann die Anordnung auch umgekehrt sein, so dass die Außenseitenflächen 30 des Gehäuses 4 mit Aussparungen 33 versehen sind, in die entsprechende Rasthaken 27 an einer Innenseite des Gehäusedeckels 16 eingreifen.

Das Gehäuse besteht vorzugsweise aus Metall, beispielsweise aus einer Aluminiumdruckgusslegierung. Dieses Material ist hinsichtlich seiner Gestaltungsmöglichkeiten sehr flexibel, dabei gleichzeitig stabil und verfügt über gute Wärmeleitungseigenschaften. Der Gehäusedeckel besteht vorzugsweise aus Kunststoff, beispielsweise aus einem spritzgegossenem Thermoplast wie Polyamid oder einem Duroplast. Gegebenenfalls kann der Gehäusedeckel 16 zur Verbesserung seiner Stabilität mit Verstärkungsfasern in Kunststoff versehen sein. Auf diese Weise kann der umlaufende Rand 18 des Gehäusedeckels 16 flexibel gehalten werden, so dass er über die Rasthaken 26 des Gehäuses 4 gleiten und sich dabei etwas aufweiten kann, bevor diese in die Aussparungen 30 an der Innenseite des Gehäusedeckels 16 einrasten.

Am Gehäusedeckel 16 können wahlweise, wie im dargestellten Ausführungsbeispiel vorgesehen, eine oder mehrere Stützsäulen 28 vorgesehen sein, die auf der Leiterplatte aufliegen, und für deren mechanische Fixierung sorgen können. Auf diese Weise kann die Leiterplatte 6 mittels der Stützsäulen 28 unter leichte Vorspannung gesetzt werden, so dass ein Schwingen der Leiterplatte 6 auch bei stärkeren Erschütterungen und/ oder Vibrationen im Fahrzeug verhindert werden kann.

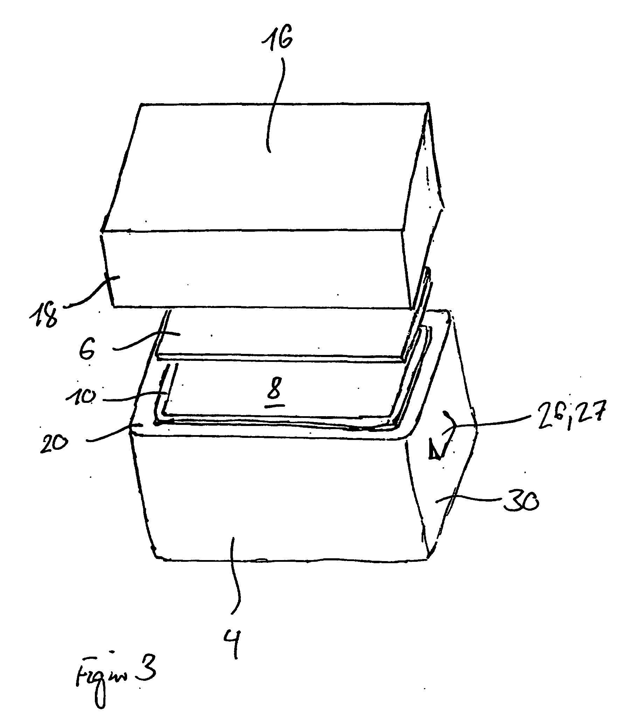

Figur 2 zeigt in einer schematischen Teilschnittansicht das' erste bzw. zweite elastische Element 12 bzw. 14 im Gehäusedeckel 16. Erkennbar ist jeweils das über die erste Nut 22 bzw. über die zweite Nut 24 hinausragende elastische Element 12 bzw. 14, das im entspannten Zustand jeweils eine dreieckförmige oder beispielsweise auch halbrundförmige Erhebung über der Innenseite 17 des Gehäusedeckels 16 bildet. Wird der Gehäusedeckel 16 auf die Gehäusekante 20 des Gehäuses 4 sowie die darauf aufliegende Leiterplatte 6 aufgedrückt, so werden die aus den Nuten 22, 24 hinausragenden Abschnitte der elastischen Elemente 12, 14 jeweils komprimiert und können auf diese Weise für eine Fixierung der Leiterplatte 6 sowie des Gehäusedeckels 16 und gleichzeitig für eine gute Abdichtung der Innenseite des Gehäuses 4 gegen äußere Medieneinflüsse sorgen.

Anhand der Explosionsdarstellung der Figur 3 sowie der bereits erläuterten Figuren 1 und 2 wird im folgenden ein erfindungsgemäßes Verfahren zur Herstellung des elektrischen Steuergeräts 2 beschrieben. Es wird ein einseitig offenes Gehäuse 4 mit einer umlaufenden bzw. unterbrochenen Auflagekante 10 innerhalb einer Öffnung 8 bereitgestellt. Auf die Auflagekante 10 des Gehäuses 4 wird eine Leiterplatte 6 mit darauf befindlicher elektrischer Schaltung aufgelegt. Es wird weiterhin ein Gehäusedeckel 16 mit zwei umlaufenden Nuten 22 bzw. 24 in einer Innenseite 17 bereitgestellt. In die umlaufenden Nuten 22, 24 werden jeweils elastische Elemente 12 bzw. 14 eingebracht.

Danach erfolgt das Aufsetzen des Gehäusedeckels 16 auf die Öffnung 8 des Gehäuses 4 unter Verrastung der beiden Teile. Beim Aufsetzen des Gehäusedeckels 16 werden die elastischen Elemente 12 bzw. 14 jeweils komprimiert, wobei das erste elastische Element 12 gegen die Leiterplatte 6 gedrückt wird. Das zweite elastische Elemente 14 wird gegen das Gehäuse 4 gedrückt, wobei dessen Inneres gegen äußere Medieneinflüsse abgedichtet wird.

Vorzugsweise können die elastischen Elemente 12 bzw. 14 mittels Spritzgussverfahren in die Nuten 22 bzw. 24 des Gehäusedeckels 16 eingebracht werden. Dies kann besonders vorteilhaft dadurch gewährleistet werden, dass der Gehäusedeckel aus Thermoplast oder Duroplast mit den darin integrierten, elastischen Elementen 12, 14 aus einem Elastomer in einen zweistufigen Spritzgussverfahren hergestellt wird.

### Bezugszeichenliste

- 2: elektrisches Steuergerät
- 4: Gehäuse
- 6: Leiterplatte
- 8: Öffnung
- 10: Auflagekante
- 12: erstes elastisches Element
- 14: zweites elastisches Element
- 16: Gehäusedeckel
- 17: Innenseite
- 18: umlaufender Rand
- 20: Gehäusekante
- 22: erste Nut
- 24: zweite Nut
- 26: Rasthaken
- 27: Rasthaken
- 28: Stützsäule
- 30: Außenseitenfläche
- 32: Aussparung
- 33: Aussparung

## Patentansprüche

1. Elektrisches bzw. elektropneumatisches und/oder elektrohydraulisches Steuergerät, insbesondere zum Einsatz in Kraftfahrzeugen, mit einem einseitig offenen Gehäuse (4) und mindestens einer in dem Gehäuse (4) angeordneten, eine elektrische Schaltung tragenden Leiterplatte (6), wobei das Gehäuse (4) innerhalb einer Öffnung (8) eine umlaufende bzw. unterbrochene Auflagekante (10) zur Auflage der Leiterplatte (6) aufweist und wobei die Leiterplatte (6) mittels wenigstens eines ersten elastischen Elements (12) auf die Auflagekante (10) gedrückt wird, wobei ein zweites elastisches Element (14) gegen das Gehäuse (4) drückt und dessen Inneres gegen äußere Medieneinflüsse abdichtet und wobei das Gehäuse (4) und ein Gehäusedeckel (16) miteinander verrastet sind,
**dadurch gekennzeichnet,**
- **dass** der Gehäusedeckel (16) mit zwei umlaufenden Nuten (22, 24) an seiner Innenseite vorgesehen ist,
- **dass** in den Nuten (22, 24) jeweils die elastischen Elemente (12, 14) eingebracht sind,
- **dass** das erste elastische Element (12) gegen die Oberseite der Leiterplatte (6) drückt und dabei bei aufgesetztem Gehäusedeckel auf der Leiterplatte aufliegt.

2. Elektrisches Steuergerät nach Anspruch 1
**dadurch gekennzeichnet, dass**
ein umlaufender Rand (18) des Gehäusedeckels (16) das Gehäuse (4) zumindest teilweise umgreift.

3. Elektrisches Steuergerät nach einem der vorhergehenden Ansprüche,
**dadurch gekennzeichnet, dass**
das zweite elastische Element (14) bei aufgesetztem Gehäusedeckel (16) auf einer umlaufenden Gehäusekante (20) aufliegt.

4. Elektrisches Steuergerät nach einem der vorhergehenden Ansprüche,
**dadurch gekennzeichnet, dass**
die elastischen Elemente (12, 14) bei aufgesetztem Gehäusedeckel (16) zumindest teilweise komprimiert sind.

5. Elektrisches Steuergerät nach einem der vorhergehenden Ansprüche,
**dadurch gekennzeichnet, dass**
die elastischen Elemente (12, 14) jeweils aus einem Elastomer gebildet sind.

6. Elektrisches Steuergerät nach einem der vorhergehenden Ansprüche,
**dadurch gekennzeichnet, dass**
das Gehäuse (4) wenigstens zwei Rasthaken (26) bzw. Aussparungen (27) aufweist, die an jeweils gegenüber liegenden Außenseitenflächen (30) des Gehäuses (4) angeordnet sind.

7. Elektrisches Steuergerät nach einem der vorhergehenden Ansprüche,
**dadurch gekennzeichnet, dass**
der Gehäusedeckel (16) wenigstens zwei Aussparungen (32) bzw. Rasthaken (33) aufweist, in die die Rasthaken (26) bzw. Aussparungen (27) des Gehäuses (4) bei aufgesetztem Gehäusedeckel (16) eingreifen.

8. Elektrisches Steuergerät nach einem der vorhergehenden Ansprüche,
**dadurch gekennzeichnet, dass**
das Gehäuse (4) im Wesentlichen aus Metall besteht.

9. Elektrisches Steuergerät nach Anspruch 8,
**dadurch gekennzeichnet, dass**
das Gehäuse (4) aus Aluminium-Druckguss besteht.

10. Elektrisches Steuergerät nach einem der vorhergehenden Ansprüche,
**dadurch gekennzeichnet, dass**
der Gehäusedeckel (16) Kunststoff aufweist.

11. Elektrisches Steuergerät nach einem der vorhergehenden Ansprüche,
**dadurch gekennzeichnet, dass**
die Leiterplatte (6) über wenigstens eine Stützsäule (28) des Gehäusedeckels (16) zusätzlich fixiert ist.

12. Verfahren zur Herstellung eines elektrischen Steuergeräts (2), das die Schritte aufweist:
- Bereitstellen eines einseitig offenen Gehäuses (4) mit einer umlaufenden bzw. unterbrochenen Auflagekante (10) innerhalb einer Öffnung (8),
- Auflegen einer Leiterplatte (6) mit darauf befindlicher elektrischer Schaltung auf die Auflagekante (10),
- Bereitstellen eines Gehäusedeckels (16) mit zwei umlaufenden Nuten (22, 24) in einer Innenseite (17),
- Einbringen von elastischen Elementen (12, 14) in die umlaufenden Nuten (22, 24),
- Aufsetzen des Gehäusedeckels (16) auf die Öffnung (8) des Gehäuses (4) derart, dass das erste elastische Element (12) gegen die Oberseite der Leiterplatte (6) drückt und dabei bei aufgesetztem Gehäusedeckel auf der Leiterplatte aufliegt und das zweite elastische Element (14) gegen das Gehäuse (4) drückt und dessen Inneres gegen äußere Medieneinflüsse abdichtet, unter Verrastung der beiden Teile (4, 16).

13. Verfahren nach Anspruch 12,
**dadurch gekennzeichnet, dass**
beim Aufsetzen des Gehäusedeckels (16) die elastischen Elemente (12, 14) komprimiert werden.

14. Verfahren nach einem der Ansprüche 12 oder 13,
**dadurch gekennzeichnet, dass**
die elastischen Elemente (12, 14) mittels Spritzgussverfahren in die Nuten (22, 24) des Gehäusedeckels (16) eingebracht werden.

15. Verfahren nach Anspruch 14,
**dadurch gekennzeichnet, dass**
der Gehäusedeckel (16) aus Thermoplast oder Duroplast mit den darin integrierten elastischen Elementen (12, 14) aus Elastomer in einem zweistufigen Spritzgussverfahren hergestellt wird.

## Claims

1. Electric or electro-pneumatic and/or electro-hydraulic controller device, particularly for use in motor vehicles, comprising a housing (4) open on one side and at least one printed-circuit board (6) disposed in said housing (4) and supporting an electrical circuit, with said housing (4) including a peripheral or discontinuous supporting edge (10) for supporting said printed-circuit board (6) and with said printed-circuit board (6) being pressed by means of at least one first resilient element (12) onto said supporting edge (10), wherein a second resilient element (14) presses against said housing (4) and seals the interior of the housing from the influences of outside media, and wherein said housing (49) and a housing cover (16) are locked with each other,
**characterised in**
- **that** said housing cover (16) is provided with two peripheral grooves (22, 24) on its inside,
- **that** each of said resilient elements (12, 14) is inserted into said grooves (22, 24), and
- **that** said first resilient element (12) presses against the upper side of the printed-circuit board (6), resting upon the printed-circuit board when the housing cover is placed on top.

2. Electric controller device according to Claim 1,
**characterised in**
**that** a peripheral edge (18) of said housing cover (16) encircles said housing (4) at least in part.

3. Electric controller device according to any of the preceding Claims,
**characterised in**
**that** said second resilient element (14) rests upon a peripheral housing edge (20) when said housing cover (16) is placed on top.

4. Electric controller device according to any of the preceding Claims, **character**
**ised in**
**that** said resilient elements (12, 14) are compressed, at least partly, when said housing cover (16) is placed on top.

5. Electric controller device according to any of the preceding Claims,
**characterised in**
**that** each of said resilient elements (12, 14) is formed of an elastomer.

6. Electric controller device according to any of the preceding Claims,
**characterised in**
**that** said housing (4) comprises at least two locking hooks (26) or recesses (27), respectively, which are disposed on respective opposite outer lateral surfaces (30) of said housing (4).

7. Electric controller device according to any of the preceding Claims,
**characterised in**
**that** said housing cover (16) comprises at least two recesses (32) or locking hooks (33), respectively, into which said locking hooks (26) or recesses (27), respectively, of said housing (4) engage when said housing cover (16) is placed on top.

8. Electric controller device according to any of the preceding Claims,
**characterised in**
**that** said housing (4) consists essentially of metal.

9. Electric controller device according to Claim 8,
**characterised in**
**that** said housing (4) consists of die-cast aluminium.

10. Electric controller device according to any of the preceding Claims,
**characterised in**
**that** said housing cover (16) consists of synthetic material.

11. Electric controller device according to any of the preceding Claims,
**characterised in**
**that** said printed-circuit board (6) is additionally fixed via at least one supporting column (28) of said housing cover (16).

12. Method of manufacturing an electric controller device (2), comprising the following steps:
- providing a housing (4) open on one end and including a peripheral or discontinuous supporting edge (10) inside an opening (8),
- placing a printed-circuit board (6) with an electric circuit mounted thereon on said supporting edge (10),
- providing a housing cover (16) with two peripheral grooves (22, 24),
- inserting resilient elements (12, 14) in said peripheral grooves (22, 24), and
- placing said housing cover (16) on the opening (8) of said housing (4) in such a way that said first resilient element (12) presses against the upper side of said printed-circuit board (6), bearing upon said printed-circuit board when said housing cover is placed on top while said second resident element (14) presses against said housing and seals the interior thereof from the influences of outside media, with said two parts (4, 16) being locked.

13. Method according to Claim 12,
**characterised in**
**that** said resilient elements (12, 14) are compressed when said housing cover (16) is placed on top.

14. Method according to any of the Claims 12 or 13,
**characterised in**
**that** said resilient elements (12, 14) are inserted into said grooves (22, 24) of said housing cover (16) by means of an injection moulding process.

15. Method according to Claim 14,
**characterised in**
**that** said housing cover (16) is manufactured of a thermoplastic material or duroplastic material with said resilient elements (12, 14) of elastomer material integrated therein in a two-stage injection-moulding process.

## Revendications

1. Appareil de commande électrique ou électropneumatique et/ou électro-hydraulique, en particulier à utiliser dans des véhicules automobiles, comportant un boîtier (4) ouvert d'un côté, et au moins une plaquette à circuit imprimé (6), placée dans le boîtier, qui porte un circuit électrique,
dans lequel le boîtier (4) présente à l'intérieur d'une ouverture (8) une arête de support (10), de pourtour ou interrompue, destinée à supporter la plaquette à circuit imprimé (6)
et la plaquette à circuit imprimée (6) est repoussée sur l'arête de support (10) à l'aide d'au moins un premier élément élastique (12),
un deuxième élément élastique (14) appuie sur le boîtier (4) et en rend l'intérieur étanche à des influences de fluides extérieurs et
le boîtier (4) et un couvercle de boîtier (16) sont encliquetés l'un dans l'autre,
**caractérisé en ce que**
- le couvercle de boîtier (16) a deux rainures (22, 24) faisant le tour sur son côté intérieur,
- les éléments élastiques (12, 14) sont introduits dans les rainures (22, 24) respectives,
- le premier élément élastique (12) repousse le côté supérieur de la plaquette à circuit imprimé (6) et s'applique donc à la plaquette à circuit imprimé lorsque le couvercle de boîtier est posé.

2. Appareil de commande électrique selon la revendication 1, **caractérisé en ce qu'**un bord (18) de pourtour du couvercle de boîtier (16) entoure au moins en partie le boîtier (4).

3. Appareil de commande électrique selon l'une des revendications précédentes, **caractérisé en ce que** le deuxième élément élastique (14) s'applique à une arête de pourtour de boîtier (20) lorsque le couvercle de boîtier (16) est posé.

4. Appareil de commande électrique selon l'une des revendications précédentes, **caractérisé en ce que** les éléments élastiques (12, 14) sont au moins en partie comprimés lorsque le couvercle de boîtier (16) est posé.

5. Appareil de commande électrique selon l'une des revendications précédentes, **caractérisé en ce que** chacun des éléments élastiques (12, 14) est en un élastomère.

6. Appareil de commande électrique selon l'une des revendications précédentes, **caractérisé en ce que** le boîtier (4) présente au moins deux crochets d'arrêt (26) ou évidements (27) disposés sur des surfaces côté extérieur (30) - du boîtier (4) - qui se font respectivement face.

7. Appareil de commande électrique selon l'une des revendications précédentes, **caractérisé en ce que** le couvercle de boîtier (16) présente au moins deux évidements (32) ou crochets d'arrêt (33) qui pénètrent dans les crochets d'arrêt (26) ou évidements (27) du boîtier (4) lorsque le couvercle de boîtier (16) est posé.

8. Appareil de commande électrique selon l'une des revendications précédentes, **caractérisé en ce que** le boîtier (4) est essentiellement en métal.

9. Appareil de commande électrique selon la revendication 8, **caractérisé en ce que** le boîtier (4) est en aluminium coulé sous pression.

10. Appareil de commande électrique selon l'une des revendications précédentes, **caractérisé en ce que** le couvercle de boîtier (16) comprend une matière plastique.

11. Appareil de commande électrique selon l'une des revendications précédentes, **caractérisé en ce que** la plaquette à circuit imprimé (6) est en outre immobilisée par au moins une colonne de soutien (28) du couvercle de boîtier (16).

12. Procédé pour fabriquer un appareil de commande électrique (2) selon les étapes suivantes :
- préparer un boîtier (4) ouvert d'un côté et comportant, à l'intérieur d'une ouverture (8), une arête de support (10) faisant le tour ou interrompue,
- appliquer sur l'arête de support (10) une plaquette à circuit imprimé (6) sur laquelle se trouve un circuit électrique,
- préparer un couvercle de boîtier (16) muni de deux rainures (22, 24) sur un côté intérieur (17),
- introduire des éléments élastiques (12, 14) dans les rainures (22, 24) faisant le tour,
- poser le couvercle de boîtier (16) sur l'ouverture (8) du boîtier (4) de telle manière que le premier élément élastique (12) repousse le côté supérieur de la plaquette à circuit imprimé (6) et s'applique donc sur la plaquette à circuit imprimé lorsque le couvercle de boîtier est posé et que le deuxième élément élastique (14) appuie sur le boîtier (4) et en rend l'intérieur étanche à des influences de fluides extérieurs grâce à l'encliquetage des deux pièces (4, 16).

13. Procédé selon la revendication 12, **caractérisé en ce que** les éléments élastiques (12, 14) sont comprimés lorsque le couvercle de boîtier (16) est posé.

14. Procédé selon l'une des revendications 12 ou 13, **caractérisé en ce que** les éléments élastiques (12, 14) sont introduits dans les rainures (22, 24) du couvercle de boîtier (16) par un procédé de moulage par injection.

15. Procédé selon la revendication 14, **caractérisé en ce qu'**on fabrique par un procédé de moulage par injection à deux étapes le couvercle de boîtier (16) en matière plastique thermoplastique ou thermodurcissable avec les éléments élastiques (12, 14) en élastomère qui y sont intégrés.
